# EUROPÄISCHE PATENTSCHRIFT

(11) **EP 1 023 772 B1**
(45) Veröffentlichungstag und Bekanntmachung des Hinweises auf die Patenterteilung: **01.10.2003**
(21) Anmeldenummer: 98943688.6
(22) Anmeldetag: 14.07.1998
(51) Int. Cl.: H03J 1/22

(54) **BEDIENELEMENT FÜR ELEKTRONISCHE GERÄTE**
OPERATING ELEMENT FOR ELECTRONIC APPLIANCES
ELEMENT DE COMMANDE DESTINE A DES APPAREILS ELECTRONIQUES

(30) Priorität: 25.10.1997 DE 19747284
(43) Veröffentlichungstag der Anmeldung: 02.08.2000
(73) Patentinhaber: ROBERT BOSCH GMBH, 70442 Stuttgart (DE)
(72) Erfinder: WALL, Holger, D-30459 Hannover (DE)
(86) Internationale Anmeldenummer: DE9801963
(87) Internationale Veröffentlichungsnummer: WO99022447

(56) Entgegenhaltungen:
- EP-A- 0 347 686
- EP-A- 0 724 278
- EP-A- 0 831 504
- EP-B- 0 366 132
- US-A- 5 647 346

## Beschreibung

Die Erfindung betrifft ein Bedienelement für elektronische Geräte mit einem Display, insbesondere Autoradios, mit einem in zwei entgegengesetzten Richtungen betätigbaren Inkrementgeber und einer Steuerung zur Umsetzung von erzeugten Inkrementimpulsen in ein entsprechendes Steuersignal zur Verstellung einer Einstellgröße des elektronischen Geräts, wobei der Inkrementgeber in einer dritten Richtung zur Anwahl einer anderen Einstellgröße betätigbar ist (EP 0 347 686).

Die zunehmende Komplexität von elektronischen Geräten, die häufig auch mit Zusatznutzen betrieben werden, wie beispielsweise Autoradios, erfordert eine kompliziertere Bedienung, die herkömmlich mit einer Erhöhung der Anzahl von Bedienknöpfen ermöglicht wird. Hierdurch wird die Bedienbarkeit des elektronischen Geräts unübersichtlich und der Benutzer häufig überfordert.

Die Lösung des Bedienproblems für komplexe elektronische Geräte geht regelmäßig dahin, die Anzahl der Bedienknöpfe zu reduzieren und diesen dafür mehr Funktionen zu verleihen. Hierzu gehört die Realisierung von sogenannten Softkeys, die durch eine Beschriftung im Display ihre aktuelle Funktion zugeschrieben bekommen.

Eine andere Möglichkeit besteht darin, eine Verstelleinrichtung, beispielsweise in Form eines Drehreglers oder einer Wippe, für die Einstellung verschiedener Bediengrößen gemeinsam auszunutzen. Hierfür ist es erforderlich, die entsprechende Bediengröße auszuwählen und dann das Verstellelement zu bedienen, um den Wert der angewählten Bediengröße zu verändern. Durch das Autoradio GRUNDIG EC 4000 RDS ist ein Drehregler in Form eines Inkrementreglers bekannt, durch dessen Bedienung in der einen Drehrichtung oder in der entgegengesetzten Drehrichtung der Wert einer angewählten Bediengröße in die eine oder andere Richtung verändert werden kann. Zum Wechseln der Bediengröße ist es möglich, den Drehregler durch Antippen umzuschalten, um eine nächste Bediengröße anzuwählen, die danach durch Drehen des Drehreglers eingestellt werden kann. Wenn bei diesem Konzept eine Vielzahl von Bediengrößen durch den Drehregler verstellbar sein sollen, ergibt sich eine umständliche sequentielle Anwahl der gewünschten Bediengröße durch eine vorgegebene Anzahl von Tippschritten. Wird versehentlich ein Tippschritt zuviel vorgenommen, müssen alle anderen Bediengrößen erneut gewählt werden, bevor die gewünschte Bediengröße eingestellt werden kann. Die Erhöhung der Übersichtlichkeit der Bedienung des elektronischen Geräts ist somit einererheblichen Reduzierung des Bedienkomforts durch das Bedienelement verbunden .

Aus der EP 347 686 A1 ist ein drehbetätigter Geber für digitale Impulse und ein Anwendungsverfahren für den Geber bekannt. Mittels des Drehgebers kann die Einstellung vorgenommen oder zu einer Unterfunktion durchgeschaltet werden. Mit der Drehachse steht ein Zug- und/oder Druckschalter in Wirkverbindung, so dass durch Abgabe von Schaltsignale in einer verabredeten Reihenfolge dem Drehgeber die Funktionenauswahl oder Funktioneneinstellung sowie Quittierungs- und/oder Speichervorgänge zugeordnet sind.

Aus der EP 366 132 B1 ist ein Multifunktionsbedieneinrichtung bekannt, bei der ein und derselbe bidirektionale Drehschalter zur Menüauswahl und individuellen Funktionsauswahl dient. Hierdurch kann z.B. eine Buchstabenfolge oder eine Wortkombination eingegeben werden.

Der Erfindung liegt daher die Problemstellung zugrunde, ein Bedienelement der eingangs erwähnten Art so auszubilden, dass nicht nur die Übersichtlichkeit der Bedienung des elektronischen Geräts durch Reduzierung der Einstellelemente verbessert sondern auch eine leichte und unkomplizierte Bedienbarkeit gegeben ist.

Zur Lösung dieses Problems ist ein Bedienelement der eingangs erwähnten Art, bei welchem durch die Betätigung des Inkrementgebers in der dritten Richtung die Steuerung umgeschaltet ist, so dass durch Inkrementimpulse des in einer der beiden entgegengesetzten Richtungen betätigten Inkrementgebers nacheinander eine Mehrzahl von auf dem Display angezeigten Einstellgrößen anwählbar und durch Rückgängigmachen der Umschaltung der Steuerung die ausgewählte Einstellgröße durch die Inkrementimpulse in ihrem Wert einstellbar ist, erfindungsgemäß dadurch gekennzeichnet, dass der Inkrementgeber eine Wippe ist und dass die dritte Richtung in einer senkrecht zur Wipprichtung liegenden Bedienebene liegt.

Bei dem erfindungsgemäßen Bedienelement wird durch die Betätigung des Inkrementgebers in der dritten Richtung eine Umschaltung derart vorgenommen, dass nach der Umschaltung mit den durch Verstellung des Inkrementgebers in den beiden entgegengesetzten Richtungen Inkrementimpulse erzeugt werden, die zur Anwahl einer gewünschten Bediengröße nutzbar sind. Spätestens durch die Umschaltung des Inkrementgebers werden somit auf dem Display die anwählbaren Bediengrößen in einer linearen Zuordnung dargestellt, so dass durch die Betätigung des Inkrementgebers in einer der beiden entgegengesetzten Richtungen ein Anwahlsignal über den Vorrat der anwählbaren Bediengröße in die eine oder andere Richtung verschoben wird. Ist die gewünschte Bediengröße dann angewählt, kann durch Rückgängigmachen der Umschaltung diese Bediengröße in ihrem Wert durch Betätigung desselben Inkrementgebers in einer der beiden entgegengesetzten Richtungen verstellt werden. Die Umschaltung führt somit in eine zweite Bedienebene, in der der ursprünglich für die Einstellung einer vorgegebenen Bediengröße vorgesehene Inkrementgeber nun für die Anwahl einer von Mehreren Bediengrößen verwendet wird. Die zweite Bedienebene ist somit hierarchisch oberhalb der normalen Bedienebene angeordnet. Durch Rückkehr in die normale Bedienebene kann die in der zweiten Bedienebene angewählte Einstellgröße nunmehr in ihrem verändert und in der gewünschten Weise eingestellt werden.

Das erfindungsgemäße Konzept kann also mit einer Wippe durchgeführt werden, wobei die Umschaltung der Steuerung durch eine Verschiebbarkeit der Wippe in einer senkrecht zur Wipprichtung liegenden Bedienebene erfolgt.

Eine vollständige Bedienung mit einem einzigen Inkrementgeber ist möglich, wenn zur Umschaltung der Steuerung der Inkrementgeber in der dritten Richtung betätigt und die Inkrementimpulse für die Anwahl einer Einstellgröße in der in der dritten Richtung betätigten Stellung des Inkrementgebers erzeugbar sind. Bei einer zusätzlichen Ausführung des Inkrementgebers als ein Drehknopf kann der Drehknopf in den beiden entgegengesetzten Drehrichtungen gedreht werden, um beispielsweise aufsteigende oder absteigende Inkremente zu erzeugen. Ist der Drehknopf eindrückbar, kann die Anwahl der Einstellgrößen durch Drehen des Drehknopfes in einer der beiden Drehrichtungen in der gedrückten Stellung vorgenommen werden. Wird der Drehknopf wieder losgelassen, kann die Verstellung der in der gedrückten Stellung angewählten Einstellgröße durch normales Drehen des Drehknopfes vorgenommen werden.

Es ist auch möglich, den Inkrementgeber in der dritten Richtung durch Antippen betätigbar auszubilden. Durch einen Tippimpuls wird dann eine Umschaltung zwischen den Bedienebenen durchgeführt, so daß nach dem Antippen die Anwahl einer Einstellgröße möglich ist. Die Rückgängigmachung findet dann durch ein erneutes Antippen statt, so daß anschließend die angewählte Einstellgröße verstellbar ist.

Das erfindungsgemäße Bedienelement läßt sich in seiner Funktionalität vielfach erweitern. Wenn beispielsweise die Anwahl einer Einstellgröße mit einem Inkrementgeber vorgenommen wird, der in der in der dritten Richtung betätigten Stellung zur Erzeugung von Inkrementimpulsen betätigt wird, kann dem bloßen Antippen des Inkrementgebers in der dritten Richtung eine andere Funktion zugeordnet werden, die auch darin bestehen kann, lediglich ein Inkrement in einer vorgegebenen Richtung zu erzeugen, so daß zusätzlich auch eine herkömmliche sequentielle Anwahl der Bediengrößen möglich ist. Ein langes Betätigen des Inkrementgebers in der dritten Richtung, ohne den Inkrementgeber in einer der beiden entgegengesetzten Richtungen zu betätigen, kann als Signal ausgewertet werden, zu einer Ausgangseinstellung zurückzukehren oder das Gerät ganz auszuschalten.

Ferner ist es möglich, eine Zeitschaltung vorzusehen, durch die das elektronische Gerät in einen Ausgangszustand zurückgestellt wird, wenn der Inkrementgeber über eine vorgegebene Zeit nicht mehr betätigt worden ist.

Es ist weiterhin möglich, durch Betätigen des Inkrementgebers in der dritten oder einer weiteren Richtung wenigstens eine weitere Umschaltung durchzuführen, in der die durch die Betätigung des Inkrementgebers in einer der ersten beiden Richtungen weitere Steuerungen durchführbar sind. Es ist also mit dem erfindungsgemäßen Bedienelement möglich, zusätzlich zu der normalen und der zweiten Bedienebene noch eine dritte oder weitere Bedienebene zu realisieren. Bei einem Drehknopf kann beispielsweise die zweite Bedienebene durch Eindrücken und die dritte Bedienebene durch Herausziehen aus einer mittleren Normalstellung des Drehknopfes realisiert sein. Eine weitere Möglichkeit besteht darin, durch einmaliges Antippen des Drehknopfes in die zweite Bedienebene, durch zweimaliges Antippen in die dritte Bedienebene usw. umzuschalten. Zur Rückgängigmachung der Umschaltung kann dann ein einfaches Antippen ausreichen.

Sollten die in einer Bedienebene vorhandenen Einstellgrößen so zahlreich sein, dass sie nicht sinnvoll auf dem Display in einer linearen Zuordnung zueinander anzeigbar sind, können nach der Umschaltung der Steuerung durch die Betätigung des Inkrementgebers in den beiden Betätigungsrichtungen unterschiedliche Gruppen von Einstellgrößen auf dem Display abrufbar sein, innerhalb derer die anschließende Auswahl der Einstellgröße durch die Inkrementimpulse durchführbar ist. Soll dann auf die nicht ausgewählte Gruppe der Einstellgrößen innerhalb der Bedienebene übergegangen werden, kann dies sinnvollerweise durch eine Rückgängigmachung der Umschaltung und eine erneute Anwahl der betreffenden Bedienebene erfolgen.

Die Erfindung soll im folgenden anhand eines in der Zeichnung dargestellten Ausführungsbeispiels näher erläutert werden. Es zeigen:
- Figur 1 -: eine Ansicht der Bedientafel eines Autoradios
- Figur 2 -: eine schematische Schaltung für das Bedienelement
- Figur 3 -: eine schematische Darstellung der Funktion eines Bedienelements
- Figur 4 -: eine schematische Darstellung der Funktion eines weiteren Bedienelements

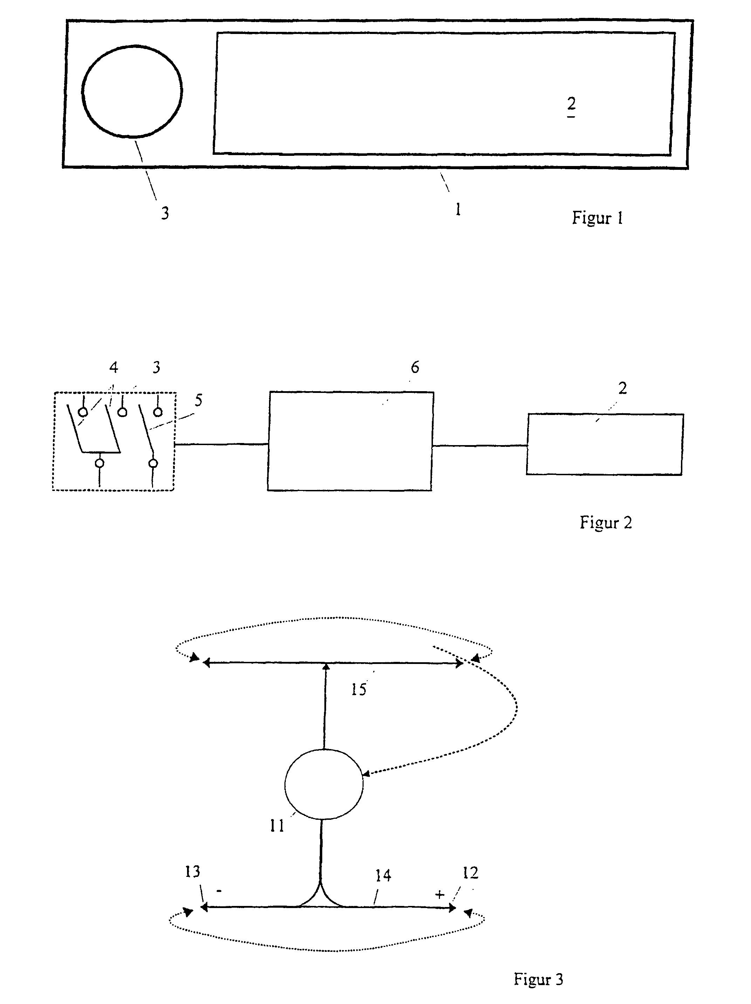

Figur 1 läßt eine Bedientafel 1 eines Autoradios erkennen, auf der ein großes Display 2 ausgebildet ist und ein einziger Bedienknopf 3 zur Steuerung aller Funktionen vorgesehen ist. Der Bedienknopf 3 ist in üblicher Weise in dem und entgegengesetzt zum Uhrzeigersinn drehbar, so daß sich zwei Verstellrichtungen ergeben. Der Drehknopf 3 ist als Inkrementgeber ausgebildet, mit dem somit keine absoluten Einstellungen sondern lediglich relative Einstellungen zu einer Ausgangseinstellung vorgenommen werden. Der Drehknopf 3 ist zusätzlich zu den beiden Drehrichtungen in Richtung seiner Drehachse eindrückbar, um so weitere Funktionen zu erfüllen.

Figur 2 zeigt die prinzipielle Schaltungsanordnung eines Bedienelements. Der als Inkrementgeber ausgebildete Drehknopf 3 weist zwei Schalter 4 auf, mit denen abhängig von der Drehrichtung des Drehknopfes 3 Inkremente in der jeweiligen Drehrichtung erzeugt werden. Ein weiterer Schalter 5 schließt einen Kontakt, wenn der Drehknopf in Richtung seiner Drehachse eingedrückt ist.

Eine an den Drehknopf 3 angeschlossene Steuerung 6 erkennt mit Hilfe eines Mikroprocessors und wertet mit Hilfe eines Zählers die Inkremente zur Erzeugung von Steuersignalen aus. Ferner steuert die Steuerung 6 das Display 2.

Eine Funktion des Drehknopfes 3 ist in Figur 3 dargestellt. In einer Ausgangsstellung 11 führt das Drehen des Drehknopfes 3 zur Erzeugung von einer Anzahl von das Maß der Verdrehung charakterisierenden Inkrementen in einer ersten Richtung 12 bzw. entgegengesetzten zweiten Richtung 13. Dabei kann in herkömmlicher Weise eine Einstellgröße des elektronischen Geräts, beispielsweise die Lautstärke, vergrößert (Richtung 12) bzw. vermindert (Richtung 13) werden. Die Ausgangsstellung 11 sorgt daher für eine Verstellung in einer ersten Bedienebene 14.

Durch Eindrücken des Drehknopfes 3 findet mit dem Schalter 5 eine Umschaltung in eine Zweite Bedienebene 15 statt. Durch Drehen des Drehknopfes 13 nach der Umschaltung in die zweite Bedienebene 15 sind in der zweiten Bedienebene 15 zahlreiche, im Display 2 dargestellte Einstellgrößen anwählbar. Da der Drehknopf 3 in beiden Richtungen zur Anwahl der Einstellgröße in der zweiten Bedienebene 15 verstellbar ist, kann ein zuviel erzeugtes Inkrement, mit dem eine Auswahl einer jenseits der gewünschten Einstellgröße liegenden Einstellgröße vorgenommen worden ist, durch Drehen in die andere Richtung sofort rückgängig gemacht werden. Nachdem die gewünschte Anwahl ausgeführt worden ist, wird der Drehknopf 3 in die Normalstellung 11 zurückgeführt, so daß in der ersten Bedienebene 14 nunmehr durch den Drehknopf 3 eine andere Einstellgröße einstellbar ist, beispielsweise die Einstellung von Tiefen oder Höhen der Lautsprecherwiedergabe des Autoradios.

Das Bedienelement 2, 3 läßt sich in besonders vorteilhafter Weise auch für die Erzeugung eines Textes auf dem Display 2 verwenden. Hierzu können in der Ausgangsstellung 11 durch Drehen des Drehknopfes 3 eingebbare Zeichen, beispielsweise Buchstaben und/oder Satzzeichen, eingestellt werden. Durch Umschalten des Drehknopfes 3 in die zweite Bedienebene 15 kann dann eine Position auf dem Display 2, beispielsweise innerhalb einer Zeile angewählt werden, in der das in der ersten Bedienebene 14 ausgewählte Zeichen zum Erscheinen gebracht wird. Als Einstellgröße der zweiten Bedienebene 15 dient daher eine Position auf dem Display 2, während die Einstellung des Wertes dieser Einstellgröße in der ersten Bedienebene 14 in der Auswahl des gewünschten Zeichens durch aufwärts bzw. abwärts laufende Inkremente, vorzugsweise im Sinne des Alphabets, erfolgt. Bei diesem Anwendungsbeispiel ist es besonders zweckmäßig, wenn durch ein kurzes Antippen des Drehknopfes 3 die nächste Einstellgröße in der zweiten Bedienebene, als hier die nächste Position eines Buchstabens oder Zeichens, anwählbar ist. Nach Beendigung der Eingabe kann durch ein langes Drücken des Drehknopfes 3 ohne eine Drehbewegung die Funktion "Texteditor" verlassen werden und die Rückstellung in eine Ausgangsposition (z.B. Lautstärkeverstellung) vorgenommen werden.

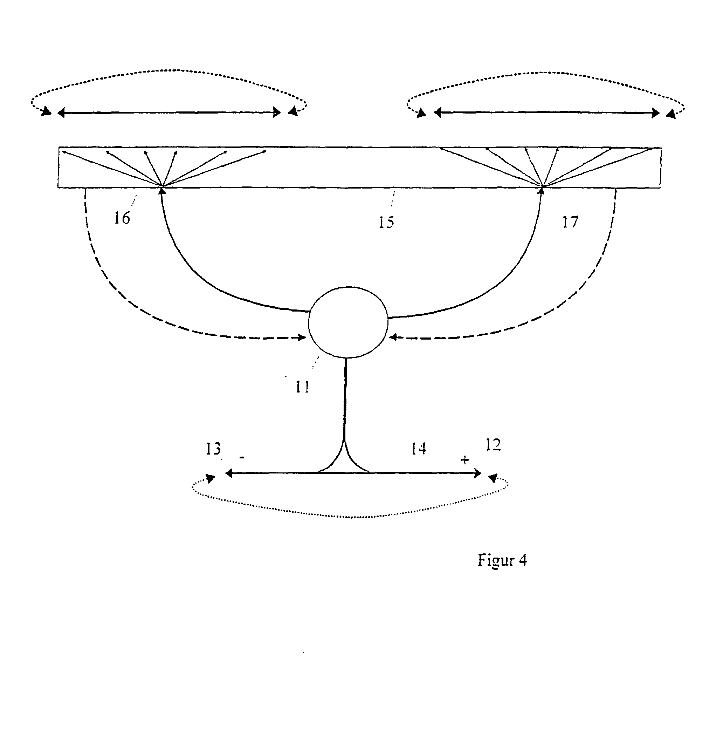

Das in Figur 4 dargestellte zweite Beispiel entspricht in der Ausgangsstellung 11 durch Anwahl der ersten Bedienebene 14 vollständig dem in Figur 3 dargestellten Beispiel. Ein Unterschied ergibt sich jedoch beim Eindrücken des Drehknopfes 3, da dadurch zwar in eine zweite Bedienebene 15 übergegangen wird, jedoch noch keine Einstellgrößen auswählbar sind. Durch eine Drehung des Drehknopfes nach links in der eingedrückten Stellung wird eine erste Gruppe 16 von Einstellgrößen ausgewählt, während eine Drehung des Drehknopfes 3 in der eingedrückten Stellung zur Auswahl einer zweiten Gruppe 17 von Einstellgrößen führen würde.

Ist beispielsweise die erste Gruppe 16 von Einstellgrößen ausgewählt worden, kann durch die Drehung des Drehknopfes 3 im bzw. entgegen dem Uhrzeigersinn eine Auswahl einer Einstellgröße aus der ersten Gruppe 16 vorgenommen werden. Durch Übergang in die Normalstellung 11 kann der Wert der ausgewählten Einstellgröße durch Drehung des Drehknopfes 3 in der Normalstellung 11, also in der ersten Bedienebene 14, eingestellt werden. Befindet sich jedoch die gewünschte Einstellgröße nicht in der ersten Gruppe 16 der Einstellgrößen, wird der Drehknopf 3 losgelassen, also in seine Normalstellung 11 zurückgeführt. Nach erneutem Drücken des Drehknopfes 3 und gleichzeitigem Drehen des Drehknopfes 3 nach rechts wird dann die andere Gruppe 17 der Einstellgrößen auf dem Display 2 dargestellt und ist nunmehr anwählbar.

Dieses Beispiel eignet sich insbesondere dann, wenn eine Vielzahl von Einstellgrößen anwählbar ist und eine Darstellung aller anwählbaren Einstellgrößen auf dem Display 2 wegen der begrenzten Größe des Displays 2 nicht möglich oder zu unübersichtlich wäre.

## Patentansprüche

1. Bedienelement für elektronische Geräte mit einem Display (2), insbesondere Autoradios, mit einem in zwei entgegengesetzten Richtungen betätigbaren Inkrementgeber (3) und einer Steuerung (6) zur Umsetzung von erzeugten Inkrementimpulsen in ein entsprechendes Steuersignal zur Verstellung einer Einstellgröße des elektronischen Geräts, wobei der Inkrementgeber (3) in einer dritten Richtung zur Anwahl einer anderen Einstellgröße betätigbar ist, wobei durch die Betätigung des Inkrementgebers (3) in der dritten Richtung die Steuerung (6) umgeschaltet ist, so dass durch Inkrementimpulse des in einer der beiden entgegengesetzten Richtungen betätigten Inkrementgebers (3) nacheinander eine Mehrzahl von auf dem Display (2) angezeigten Einstellgrößen anwählbar und durch Rückgängigmachen der Umschaltung der Steuerung (6) die angewählte Einstellgröße durch die Inkrementimpulse in ihrem Wert einstellbar ist, **dadurch gekennzeichnet, dass** der Inkrementgeber (3) eine Wippe ist und dass die dritte Richtung in einer senkrecht zur Wipprichtung liegenden Bedienebene liegt.

2. Bedienelement nach Anspruch 1, **dadurch gekennzeichnet, dass** zur Umschaltung der Steuerung (6) der Inkrementgeber (3) in der dritten Richtung betätigt und die Inkrementimpulse für die Anwahl einer Einstellgröße in der in der dritten Richtung betätigten Stellung des Inkrementgebers (3) erzeugbar sind.

3. Bedienelement nach einem der vorhergehenden Ansprüche, **dadurch gekennzeichnet, dass** der Inkrementgeber (3) in der dritten Richtung durch Antippen betätigbar ist.

4. Bedienelement nach einem der vorhergehenden Ansprüche, **dadurch gekennzeichnet, dass** eine Zusatzfunktion durch Antippen des Inkrementgebers (3) in der dritten Richtung ausführbar ist.

5. Bedienelement nach einem der vorhergehenden Ansprüche, **dadurch gekennzeichnet, dass** eine Zusatzfunktion durch Betätigen des Inkrementgebers (3) in der dritten Richtung über eine vorbestimmte Zeitdauer ohne Betätigung in einer der ersten beiden Richtungen auslösbar ist

6. Bedienelement nach einem der vorhergehenden Ansprüche, **dadurch gekennzeichnet, dass** durch eine Betätigung des Inkrementgebers (3) in der dritten oder einer weiteren Richtung wenigstens eine weitere Umschaltung durchführbar ist, in der durch die Betätigung des Inkrementgebers (3) in einer der ersten beiden Richtungen weitere Steuerungen durchführbar sind.

7. Bedienelement nach einem der vorhergehenden Ansprüche, **dadurch gekennzeichnet, dass** nach der Umschaltung der Steuerung (6) durch die Betätigung des Inkrementgebers (3) in den beiden Betätigungsrichtungen unterschiedliche Gruppen (16, 17) von Einstellgrößen auf dem Display (2) abrufbar sind, innerhalb derer die anschließende Auswahl der Einstellgröße durch die Inkrementimpulse durchführbar sind.

## Claims

1. Control element for electronic appliances having a display (2), particularly car radios, having an incremental sensor (3) which can be actuated in two opposite directions and having a controller (6) for converting generated increment pulses into a corresponding control signal for varying an adjustment variable for the electronic appliance, where the incremental sensor (3) can be actuated in a third direction for the purpose of selecting another adjustment variable, where actuation of the incremental sensor (3) in the third direction means that the controller (6) has been changed over, so that increment pulses from the incremental sensor (3) actuated in one of the two opposite directions can successively select a plurality of adjustment variables displayed on the display (2), and reversing the changeover of the controller (6) allows the value of the selected adjustment variable to be adjusted by the increment pulses, **characterized in that** the incremental sensor (3) is a rocker and **in that** the third direction lies in a control plane which is at right angles to the rocking direction.

2. Control element according to Claim 1, **characterized in that** the controller (6) is changed over by actuating the incremental sensor (3) in the third direction and by being able to generate the increment pulses for selecting an adjustment variable **in that** position of the incremental sensor (3) which is actuated in the third direction.

3. Control element according to one of the preceding claims, **characterized in that** the incremental sensor (3) can be actuated in the third direction by means of a momentary touch.

4. Control element according to one of the preceding claims, **characterized in that** a supplementary function can be performed by momentarily touching the incremental sensor (3) in the third direction.

5. Control element according to one of the preceding claims, **characterized in that** a supplementary function can be triggered by actuating the incremental sensor (3) in the third direction for a predetermined period of time without actuating it in one of the first two directions.

6. Control element according to one of the preceding claims, **characterized in that** actuating the incremental sensor (3) in the third or in another direction allows at least one further changeover to be made in which actuating the incremental sensor (3) in one of the first two directions allows further control operations to be performed.

7. Control element according to one of the preceding claims, **characterized in that**, following changeover of the controller (6) as a result of actuation of the incremental sensor (3) in the two directions of actuation, different groups (16, 17) of adjustment variables can be retrieved on the display (2), within which groups the subsequent selection of the adjustment variable by the increment pulses can be made.

## Revendications

1. Elément de commande d'un appareil électronique comportant un afficheur (écran) (2), notamment un autoradio ayant un capteur incrémental (3) qui peut être actionné dans deux directions opposées ainsi qu'une commande (6) pour convertir les impulsions incrémentales générées en un signal de commande correspondant pour régler une grandeur de réglage de l'appareil électronique, selon lequel le capteur incrémental (3) peut être actionné dans une troisième direction pour sélectionner une autre grandeur de réglage,
élément qui par l'actionnement du capteur incrémental (3) dans la troisième direction commute la commande (6) pour que les impulsions incrémentales du capteur incrémental (3) actionné dans l'une des deux directions opposées permettent de sélectionner successivement l'une des différentes grandeurs de réglage affichées sur l'écran (2), alors qu'en annulant la commutation de la commande (6) on règle la valeur de la grandeur de réglage sélectionnée par des impulsions incrémentales,
**caractérisé en ce que**
le capteur incrémental (3) est une touche à bascule et la troisième direction est située dans un plan de commande perpendiculaire à la direction de basculement.

2. Elément de commande selon la revendication 1,
**caractérisé en ce que**
pour commuter la commande (6) on actionne le capteur incrémental (3) dans la troisième direction, et les impulsions incrémentales pour sélectionner une grandeur de réglage sont générées dans la position du capteur incrémental (3) actionné dans la troisième direction.

3. Elément de commande selon l'une des revendications précédentes,
**caractérisé en ce que**
le capteur incrémental (3) est actionné dans la troisième direction par le toucher.

4. Elément de commande selon l'une des revendications précédentes,
**caractérisé en ce qu'**
une fonction supplémentaire est exécutée par un toucher du capteur incrémental (3) dans la troisième direction.

5. Elément de commande selon l'une des revendications précédentes,
**caractérisé en ce qu'**
une fonction supplémentaire est déclenchée par l'actionnement du capteur incrémental (3) dans la troisième direction pendant une durée prédéterminée sans l'actionner dans l'une des deux premières directions.

6. Elément de commande selon l'une des revendications précédentes,
**caractérisé en ce qu'**
en actionnant le capteur incrémental (3) dans la troisième direction ou dans une autre direction, on effectue au moins une autre commutation dans laquelle on effectue d'autres commandes par l'actionnement du capteur incrémental (3) dans l'une des deux premières directions.

7. Elément de commande selon l'une des revendications précédentes,
**caractérisé en ce qu'**
après commutation de la commande (6) par l'actionnement du capteur incrémental (3) on peut appeler des groupes différents (16, 17) de grandeur de réglage sur l'écran (2) dans les deux directions d'actionnement, groupes à l'intérieur desquels on exécute la sélection consécutive des grandeurs de réglage par des impulsions incrémentales.
